# EUROPEAN PATENT SPECIFICATION

(11) **EP 2 901 827 B1**
(45) Date of publication and mention of the grant of the patent: **21.11.2018**
(21) Application number: 13774535.2
(22) Date of filing: 16.09.2013
(51) Int. Cl.: H05K 3/00, H05K 3/12, H05K 13/04, H04N 5/225, H05K 3/34

(54) **DISPENSING SYSTEM AND METHOD OF DISPENSING MATERIAL BASED ON ANGULAR LOCATE FEATURE**
ABGABESYSTEM UND VERFAHREN ZUR ABGABE EINES MATERIALS AUF BASIS VON WINKELORTUNGSMERKMALEN
PROCÉDÉ DE DISTRIBUTION D'UN MATÉRIAU BASÉ SUR LA CARACTÉRISTIQUE DE LOCALISATION ANGULAIRE

(30) Priority: 28.09.2012 US 201213630259
(43) Date of publication of application: 05.08.2015
(73) Proprietor: Illinois Tool Works Inc., Glenview, IL 60025 (US)
(72) Inventor: BLOOM, Jonathan, Joel, Glenview, IL 60026 (US); DONELAN, Michael, E., Glenview, IL 60026 (US)
(74) Representative: Trinks, Ole
(86) International application number: PCT/US2013/059852
(87) International publication number: WO 2014/052051

(56) References cited:
- US-A1- 2007 157 462
- US-A1- 2008 250 951
- US-A1- 2008 296 311
- US-A1- 2011 002 056
- US-A1- 2011 255 000

## Description

### BACKGROUND OF THE DISCLOSURE

### 1. Field of the Disclosure

This disclosure relates generally to apparatus and methods for dispensing a viscous material on a substrate, such as a printed circuit board, and more particularly to a system and related methods for accurately dispensing material based on locating an angular feature on the circuit board.

### 2. Discussion of Related Art

A dispensing system according to the preamble of claim 1 and a method according to the preamble of claim 8 are known from US 2008/250951 A1. The system requires two fiducials for orienting a circuit board. US 2011/255000 A1 discloses a system having an alignment structure comprising notches with which radially extending tabs of a camera module mate in order to align said camera module.

There are several types of prior art dispensing systems used for dispensing precise amounts of liquid or paste for a variety of applications. One such application is the assembly of integrated circuit chips and other electronic components onto circuit board substrates. In this application, automated dispensing systems are used for dispensing very small amounts, or dots, of viscous material onto a circuit board. The viscous material may include liquid epoxy or solder paste, or some other related material. Prior to performing a dispensing operation, the circuit board must be aligned or otherwise registered with a dispenser of the dispensing system. In one known method, this may be achieved by employing a vision system of the dispensing system to verify the location of landmarks, otherwise known as fiducials, on the circuit board. Specifically, to align the circuit board with the dispensing unit of the dispensing system, images of at least two fiducials are taken by a camera of the vision system. If the circuit board is out of position, a gantry capable of moving the dispenser may be manipulated to account for the actual position of the circuit board. In another embodiment, a support surface upon which the circuit board rests may be manipulated to accurately position the circuit board prior to performing a dispense operation.

One issue associated with the use of identifying fiducials to align the circuit board with the dispensing unit is when the area requiring dispensing is not well defined with reference to the fiducials. For example, if the area to dispense is not referenced with respect to the fiducials, the resulting dispense operation may be very inaccurate, and under many instances, may not meet the processing requirements.

### SUMMARY OF THE DISCLOSURE

The present disclosure describes a technique of dispensing material onto substrates having areas that are not well defined by locating one or more angular features on the substrate (as well as one fiducial) and dispensing material based on the angular feature(s).

This technique includes using a single fiducial to determine the location and orientation of an object to be dispensed on and using this information to orient a dispensing unit relative to the found object to enhance the ability to accurately dispense a line of material or one or more dots of material located on a substrate, such as a circuit board. To dispense a line accurately on a substrate, an object (e.g., a component mounted on a circuit board or the like) is located on the circuit board and the location, orientation and angle of the object is determined to dispense a line relative to the object. While the dispensed line is frequently perpendicular or parallel to the found orientation of the object, the dispensed line is not required to be perpendicular or parallel. The dispensed line may be straight or in the form of an arc. The dispensed line may be contiguous or in the form of one or more dots or line segments. Line patterns and sub-patterns may be utilized as well. When dispensing, sensing a z-axis height above the circuit board may be used. To enhance the accuracy of the dispense operation, a subset of features of the object may be selected.

One aspect of the present disclosure is directed to a dispensing system for depositing material on an electronic substrate. The dispensing system includes a frame, a dispensing unit gantry movably coupled to the frame, and a dispensing unit coupled to the dispensing unit gantry. The dispensing unit is configured to deposit material onto the substrate during the dispense operation. The dispensing unit further includes a vision system gantry coupled to the frame and a vision system coupled to the vision system gantry. The vision system is configured to obtain one or more images of the electronic substrate prior to performing the dispense operation. A controller is coupled to the dispensing unit gantry, the dispensing unit, the vision system gantry, and the vision system. The controller is configured to obtain an image of a fiducial provided on the electronic substrate, orient an object with respect to the dispensing unit, and perform a dispense operation to secure the object to the electronic substrate. The controller is further configured to obtain an image of at least a portion of the object, which is an electronic component mounted on the electronic substrate, and further configured to determining an orientation of the object based on a location of features of the object with respect to a known location of the single fiducial of the electronic substrate and a position of the dispensing unit.

Embodiments of the dispensing system further may include a support assembly coupled to the frame. The support assembly may be configured to support the electronic substrate during a dispense operation. The controller further may be configured to manipulate the vision system with the vision gantry system to move to a position defined by a feature of the object and to acquire the image. Performing a dispense operation may include dispensing material in the shape of an arc. The object may be a camera having a body and a plurality of tabs extending from a periphery of the body. The dispensing unit may be configured to dispense material between adjacent tabs. The controller further may be configured to dispense lines of material and/or dots of material. The dispensing unit may include a sensor configured to sense a z-axis height on the electronic substrate. Another aspect of the disclosure is directed to a method of depositing material on an electronic substrate with a dispensing system of the type including a frame, a dispensing unit gantry movably coupled to the frame, a dispensing unit coupled to the dispensing unit gantry, the dispensing unit being configured to deposit material onto the substrate during the dispense operation, a vision system gantry coupled to the frame, and a vision system coupled to the vision system gantry, the vision system being configured to obtain one or more images of the electronic substrate prior to performing the dispense operation, wherein the area requiring dispensing is not well defined. The method further comprises: obtaining an image of a fiducial provided on the electronic substrate; orienting an object with respect to the dispensing unit; and performing a dispense operation to secure the object to the electronic substrate, obtaining an image of at least a portion of the object, which is an electronic component mounted on the electronic substrate; determining an orientation of the object based on a location of features of the object with respect to a known location of the single fiducial of the electronic substrate and a position of the dispensing unit.

Embodiments of the method further may include sensing a z-axis height on the electronic substrate and/or supporting the electronic substrate during a dispense operation with a support assembly coupled to the frame. The method may be performed under the control of a controller configured to manipulate the vision system with the vision gantry system to move to a position defined by a feature of the object and to acquire the image. The controller further may be configured to dispense lines of material and/or dots of material. Performing a dispense operation may include dispensing material in the shape of an arc. The object may be a camera having a body and a plurality of tabs extending from a periphery of the body. The dispensing unit may be configured to dispense material between adjacent tabs.

### BRIEF DESCRIPTION OF THE DRAWINGS

The accompanying drawings are not intended to be drawn to scale. In the drawings, each identical or nearly identical component that is illustrated in various figures is represented by a like numeral. For purposes of clarity, not every component may be labeled in every drawing. In the drawings:
FIG. 1 is a schematic view of a dispenser of an embodiment of the present disclosure;
FIG. 2 is a schematic block diagram of a method of dispensing material based on the angular location of a feature;
FIG. 3 is a top plan view of an exemplary object provided on a substrate, such as a printed circuit board;
FIGS. 4-8 are screen shots of exemplary user interfaces used to perform an angular locate command of a method of the present disclosure; and
FIG. 9 is an image of a sample showing found angular locate features.

### DETAILED DESCRIPTION OF THE DISCLOSURE

For the purposes of illustration only, and not to limit the generality, the present disclosure will now be described in detail with reference to the accompanying figures. This disclosure is not limited in its application to the details of construction and the arrangement of components set forth in the following description or illustrated in the drawings. The principles set forth in this disclosure are capable of other embodiments and of being practiced or carried out in various ways. Also the phraseology and terminology used herein is for the purpose of description and should not be regarded as limiting. The use of "including," "comprising," "having," "containing," "involving," and variations thereof herein, is meant to encompass the items listed thereafter and equivalents thereof as well as additional items.

Various embodiments of the present disclosure are directed to viscous material dispensing systems, devices including dispensing systems, and methods of locating objects on electronic substrates, such as printed circuit boards, and performing dispensing operations on the substrates. Embodiments disclosed herein are directed to techniques for dispensing material on an electronic substrate by using a single fiducial and by locating and orienting an object, and using the location of the object to orient a dispensing unit or pump of the dispensing system to enhance a dispense operation.

The systems and methods disclosed herein may frequently perform a dispense operation that is perpendicular or parallel to the found orientation of the object; however, this is not a requirement. The dispensed line may be straight or in the form of an arc.

The systems and methods further enable the accurate dispense of dots or line segments. Specifically, a dispensing unit of the dispensing system may be modified to dispense dots.

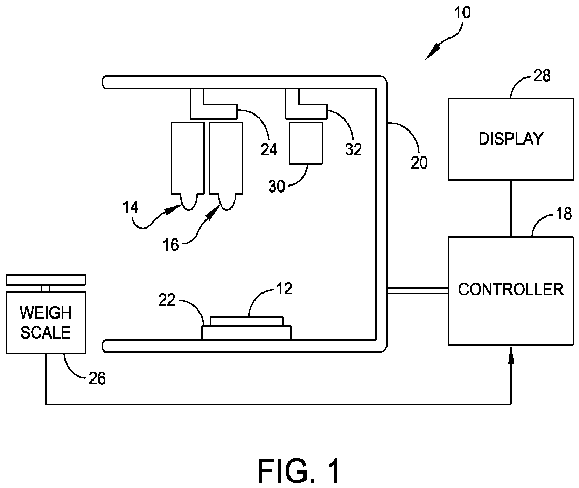

FIG. 1 schematically illustrates a dispenser, generally indicated at 10, according to one embodiment of the present disclosure. The dispenser 10 is used to dispense a viscous material (e.g., an adhesive, encapsulent, epoxy, solder paste, underfill material, etc.) or a semi-viscous material (e.g., soldering flux, etc.) onto an electronic substrate 12, such as a printed circuit board or semiconductor wafer. The dispenser 10 may alternatively be used in other applications, such as for applying automotive gasketing material or in certain medical applications. It should be understood that references to viscous or semi-viscous materials, as used herein, are exemplary and intended to be nonlimiting. The dispenser 10 includes first and second dispensing units or heads, generally indicated at 14 and 16, respectively, and a controller 18 to control the operation of the dispenser. Although two dispensing units are shown, it should be understood that one or more dispensing units may be provided.

The dispenser 10 may also include a frame 20 having a base or support 22 for supporting the substrate 12, a dispensing unit gantry 24 movably coupled to the frame 20 for supporting and moving the dispensing units 14, 16, and a weight measurement device or weigh scale 26 for weighing dispensed quantities of the viscous material, for example, as part of a calibration procedure, and providing weight data to the controller 18. A conveyor system (not shown) or other transfer mechanism, such as a walking beam may be used in the dispenser 10 to control loading and unloading of substrates to and from the dispenser. The gantry 24 can be moved using motors under the control of the controller 18 to position the dispensing units 14, 16 at predetermined locations over the substrate. The dispenser 10 may include a display unit 28 connected to the controller 18 for displaying various information to an operator. There may be an optional second controller for controlling the dispensing units. Also, each dispensing unit 14, 16 can be configured with a z-axis sensor to detect a height at which the dispensing unit is disposed above the electronic substrate 12 or above a feature mounted on the electronic substrate. The z-axis sensor is coupled to the controller 18 to relay information obtained by the sensor to the controller.

Prior to performing a dispensing operation, as described above, the substrate, e.g., printed circuit board, must be aligned or otherwise in registration with a dispenser of the dispensing system. The dispenser further includes a vision system 30, which is coupled to a vision system gantry 32 movably coupled to the frame 20 for supporting and moving the vision system. As described, the vision system 30 is employed to verify the location of landmarks, known as fiducials, on the substrate. Once located, the controller can be programmed to manipulate the movement of one or both of the dispensing units 14, 16 to dispense material on the electronic substrate.

Systems and methods of the present disclosure are directed to dispensing material onto a substrate, e.g., a circuit board, by locating an object provided on the substrate with both location and angular components. The description of the systems and methods provided herein reference exemplary electronic substrates 12 (e.g., printed circuit boards), which are supported on the support 22 of the dispenser 10. In one embodiment, the dispense operation is controlled by the controller 18, which may include a computer system configured to control material dispensers. In another embodiment, the controller 18 may be manipulated by an operator. The controller 18 is configured to manipulate the movement of the vision system gantry 32 to move the vision system so as to obtain one or more images of the electronic substrate 12. The controller 18 further is configured to manipulate the movement of the dispensing unit gantry 24 to move the dispensing units 14, 16 to perform dispensing operations.

The angular locate feature of the systems and methods of the present disclosure uses the known geometry of a special object, which provides x-axis, y-axis and theta information derived from its relative position with respect to one fiducial provided on the electronic substrate. In one embodiment, the special object may be an item that is mounted on the substrate, such as a mega pixel camera. Such a camera typically includes features that are difficult to orient with respect to the electronic substrate and the dispenser. Specifically, one issue associated with the use of such cameras is the difficulty of aligning the camera and the electronic substrate with the dispensing unit is when the area requiring dispensing is not well defined with reference to the camera. For example, if the area to dispense is not referenced with respect to the camera, the resulting dispense operation may be very inaccurate, and under many instances, may not meet the processing requirements.

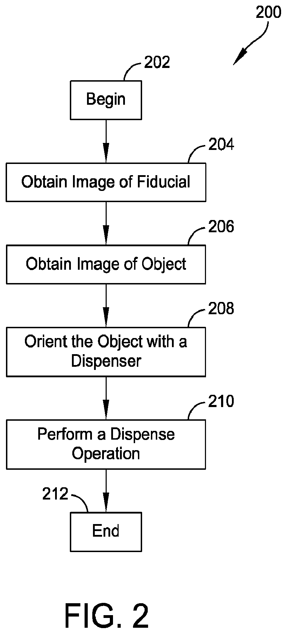

In one embodiment, an exemplary method is illustrated in FIG. 2. As shown, the method of dispensing material based on locating angular features of an object is generally indicated at 200.

As shown, the method begins at 202. At 204, the vision system is employed to obtain an image of one known fiducial. In most applications fiducials are located in known locations on the substrate or carrier, such as the corners of the electronic substrate, and two fiducials are located. The location of the fiducial is stored by the controller of the dispenser.

At 206, the vision system is further employed to obtain an image or images of the object. In a certain embodiment, the object is a camera having features, such as tabs. In some embodiments, the camera may be inserted into a feature mounted on the electronic substrate, such as a circular barrel or rim. When inserted, the orientation of the features with respect to the electronic substrate is unknown. As with the fiducial, the location of the object is stored by the controller of the dispenser.

At 208, the controller determines the orientation of the object based on the location of the features of the object with respect to the known location of the fiducial of the electronic substrate and the position of the dispensing unit of the dispenser. With the orientation of the object known, the areas requiring dispensing, e.g., the areas between the features of the object, can be determined.

At 210, a dispense operation is performed. In one embodiment, material, such as epoxy, is dispensed between the tabs of the camera in a slot between the camera and an inner wall of the barrel. The dispense operation is performed under the control of the controller.

At 212, once the dispense operation completes dispensing material the method ends.

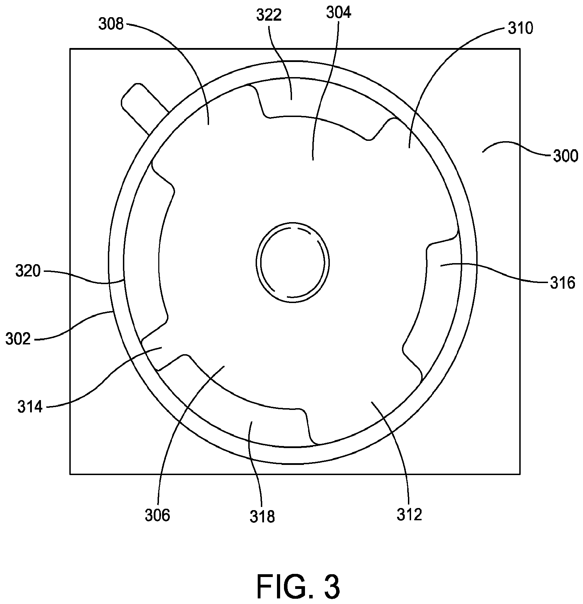

FIG. 3 illustrates an image of a portion of an electronic substrate 300. As shown, a support 302 is mounted on the electronic substrate 300 by any suitable method. In one embodiment, the support 302 is a circular barrel or rim, which is configured to receive an object 304, such as a mega pixel camera, so that the object is mounted within the support. As shown, the camera 304 includes a circular body 306, three larger tabs 308, 310, 312 and one smaller tab 314, each of the tabs extending beyond a periphery of the body. The arrangement is such that the camera 304 is inserted into the barrel 302 and secured to the electronic substrate 300 by a suitable adhesive, such as adhesive or epoxy.

When inserted, the camera 304 is not oriented with respect to the barrel 302 and the electronic substrate 300. Thus, the tabs 308, 310, 312, 314 of the camera 304 are oriented randomly with respect to the barrel 302 and the board 300. When securing the camera 304 to the electronic substrate 300, assembly material (e.g., adhesive) is dispensed within slots 316, 318, 320, 322 defined between an outer surface of the body 306 of the camera 302, the tabs 308, 310, 312, 314 of the camera and an inner surface of the barrel. The system and method of the present disclosure is designed to enable the dispensing unit of the dispenser to dispense material within the slots, which are randomly oriented with respect to the barrel 302 and the electronic substrate 300.

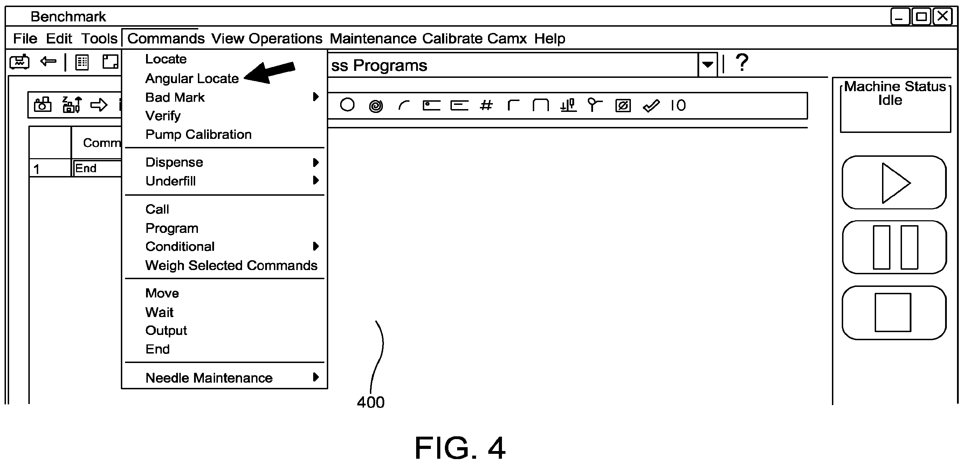

FIGS. 4-8 are screen shots of exemplary user interfaces used to perform an angular locate command of a method of the present disclosure. As shown, with reference to FIG. 4, a graphical user interface 400 is provided include an angular locate feature. A sub-program may be established to teach the angular locate fiducial and associate arcs, which can be called by the main program. From the commands menu, the angular locate command is selected.

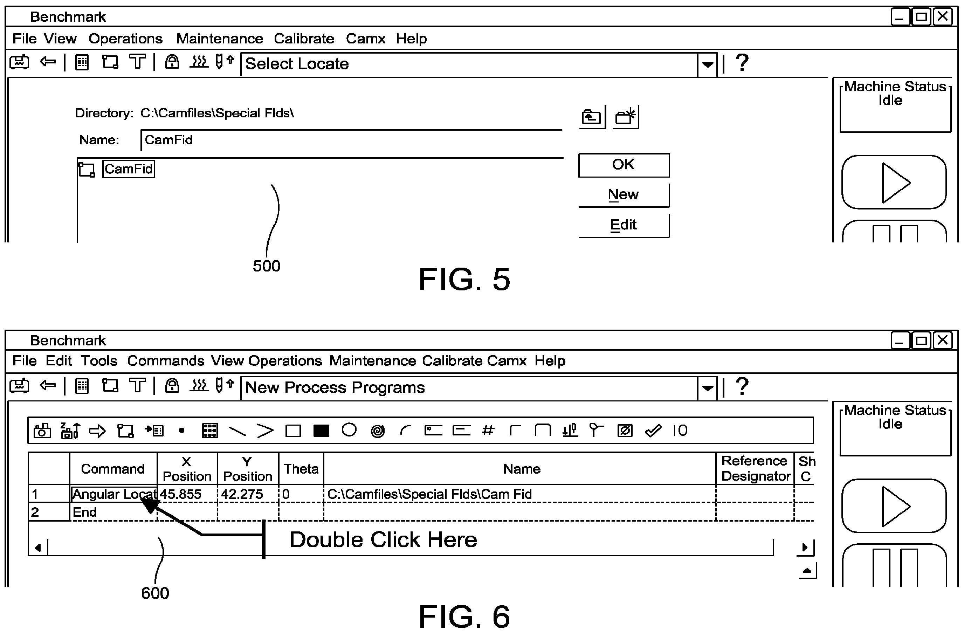

Referring to FIG. 5, when prompted to select a fiducial on graphical user interface 500, the operator or the controller navigates to a predetermined file (e.g., C:\CamFiles\SpecialFids), and selects the CamFid command,. The operator or the controller then jogs the gantry to center the vision system in the center of the object (e.g., the camera) by using the cross-hairs on the display.

Referring to FIG. 6, with reference to graphical user interface 600, by double clicking the angular locate command, the operator or the controller selects the command grid.

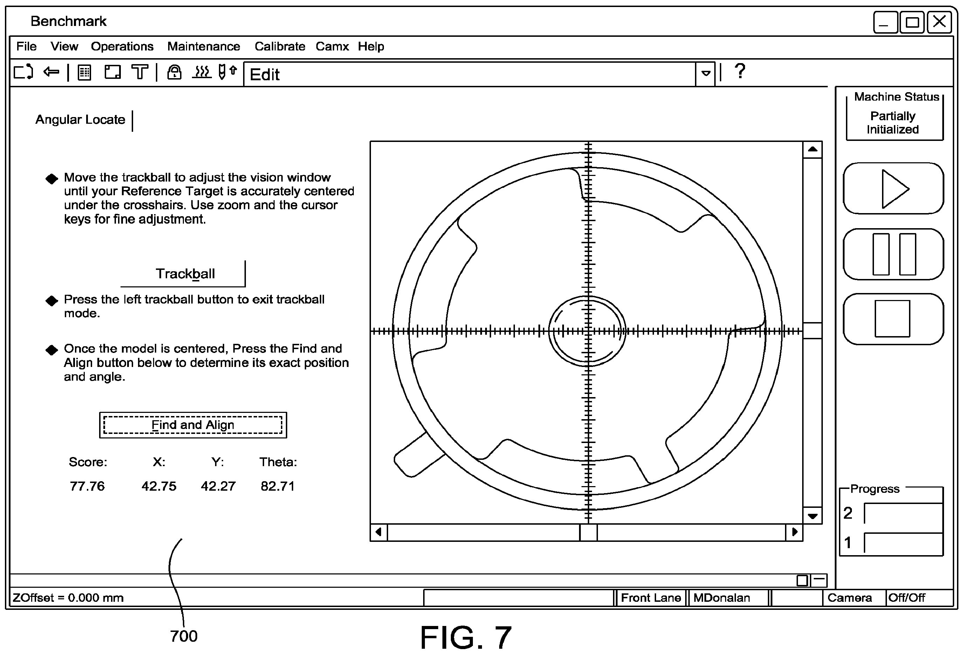

Referring to FIG. 7, with reference to graphical user interface 700, the operator or the controller next clicks a find and align button on the angular locate screen. This action determines the reference x-axis, y-axis and theta angle of the model. By pressing the find and align button, the operator or the controller fills these reference points in the interface. In certain embodiments, it should be noted that the search scores for these special models typically range in the seventies. When using an interactive mode, the operator then selects and presses "OK."

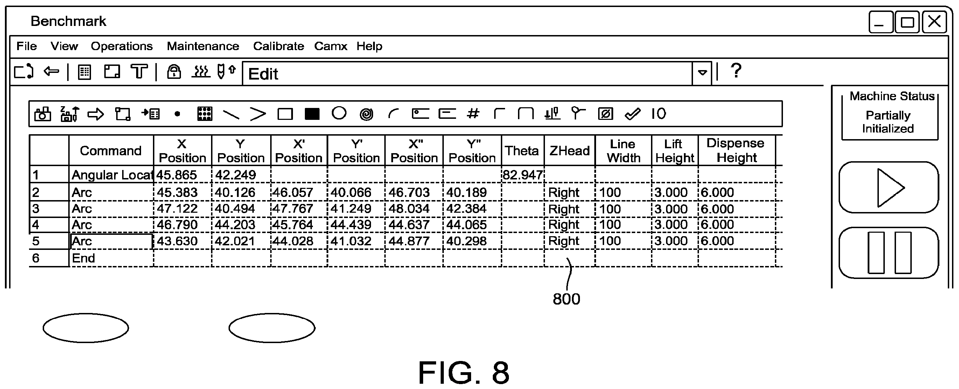

Referring to FIG. 8, with reference to graphical user interface 800, it should be noted that when the angular locate dialog is completed, the theta field of the command grid is filled in with the position locations of the arc. The operator or the controller then proceeds to add the arc commands.

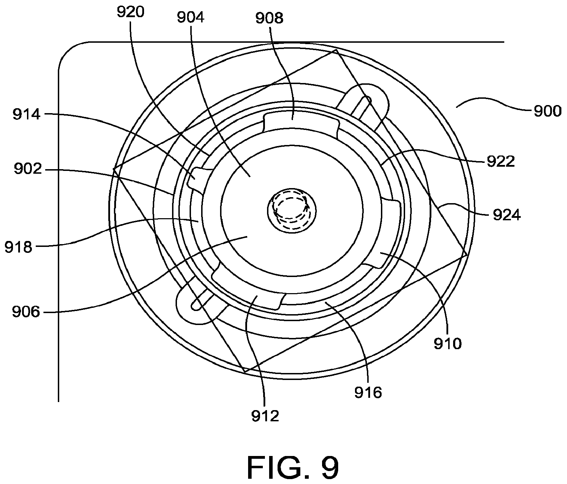

Referring to FIG. 9, once oriented, a box is displayed over an object to represent an accurate orientation of the object 904 with respect to the substrate 900 and the dispensing unit of the dispenser. Box 924 represents the proper orientation of the object 904 with respect to the support 902 and the electronic substrate 900. Once properly oriented, a dispense operation can take place in which material is dispensed in the spaces 916, 918, 920, 922 between adjacent tabs 908, 910, 912, 914 of the object 904, e.g., the camera. Any other object that has a random orientation relative to the substrate will be a candidate for performing the methods disclosed herein. For example, chips, covers, small switches, and other devices that are subassemblies in a carrier (e.g., 100 plus units) may be oriented and dispensed upon by using the methods disclosed herein.

The computer system may include an operating system that manages at least a portion of the hardware elements included in the computer system. Usually, a processor or controller executes an operating system which may be, for example, a Windows-based operating system, such as, Windows NT, Windows 2000 (Windows ME), Windows XP or Windows Vista operating systems, available from the Microsoft Corporation, a MAC OS System X operating system available from Apple Computer, one of many Linux-based operating system distributions, for example, the Enterprise Linux operating system available from Red Hat Inc., a Solaris operating system available from Sun Microsystems, or a UNIX operating system available from various sources. Many other operating systems may be used, and the embodiments disclosed herein are not intended to be limited to any particular implementation.

The processor and operating system together define a computer platform for which application programs in high level programming languages may be written. These component applications may be executable, intermediate, for example, C-, bytecode or interpreted code which communicates over a communication network, for example, the Internet, using a communication protocol, for example, TCP/IP. Similarly, aspects in accord with the present disclosure may be implemented using an object-oriented programming language, such as .Net, SmallTalk, Java, C++, Ada, or C# (C-Sharp). Other object-oriented programming languages may also be used. Alternatively, functional, scripting, or logical programming languages may be used.

Additionally, various aspects and functions in accordance with the present disclosure may be implemented in a non-programmed environment, for example, documents created in HTML, XML or other format that, when viewed in a window of a browser program, render aspects of a graphical-user interface or perform other functions. Further, various embodiments in accord with the present disclosure may be implemented as programmed or non-programmed elements, or any combination thereof. For example, a web page may be implemented using HTML while a data object called from within the web page may be written in C++. Thus, the disclosure is not limited to a specific programming language and any suitable programming language could also be used.

It should be noted that systems and methods described herein may be performed on objects other than mega pixel cameras. For example, the method may be performed on any type of electronic component mounted on an electronic substrate. The geometry of the object should be known prior to performing the method.

Having thus described several aspects of at least one embodiment of this disclosure, it is to be appreciated various alterations, modifications, and improvements will readily occur to those skilled in the art. Such alterations, modifications, and improvements are intended to be part of this disclosure, and are intended to be within the scope of the invention. Accordingly, the foregoing description and drawings are by way of example only.

## Claims

1. A dispensing system for depositing material on an electronic substrate (12, 300), the dispensing system comprising:
a frame (20);
a dispensing unit gantry (24) movably coupled to the frame (20);
a dispensing unit (14, 16) coupled to the dispensing unit gantry (24), the dispensing unit (14, 16) being configured to deposit material onto the substrate (12, 300) during the dispense operation;
a vision system gantry (32) coupled to the frame (20);
a vision system (30) coupled to the vision system gantry (32), the vision system (30) being configured to obtain one or more images of the electronic substrate (12, 300) prior to performing the dispense operation; and
a controller (18) coupled to the dispensing unit gantry (24), the dispensing unit (14, 16), the vision system gantry (32), and the vision system (30), the controller (18) being configured to
obtain an image of a fiducial provided on the electronic substrate (12, 300),
orient an object (304) with respect to the dispensing unit (14, 16), and perform a dispense operation to secure the object (304) to the electronic substrate (12, 300),
**characterized in that**
the controller (18) is further configured to obtain an image of at least a portion of the object (304), which is an electronic component mounted on the electronic substrate (12, 300), and
further configured to determining an orientation of the object (304) based on a location of features of the object (304) with respect to a known location of the single fiducial of the electronic substrate (12, 300) and a position of the dispensing unit (14, 16).

2. The dispensing system of claim 1, wherein the controller (18) further is configured to manipulate the vision system (30) with the vision system gantry (32) to move to a position defined by a feature of the object (304) and to acquire the image.

3. The dispensing system of claim 1 or 2, wherein performing a dispense operation includes dispensing material in the shape of an arc.

4. The dispensing system of one of claims 1 to 3, wherein the object (304) is a camera having a body (306) and a plurality of tabs (308, 310, 312, 314) extending from a periphery of the body (306),
wherein the dispensing unit (14, 16) is configured to dispense material between adjacent tabs (308, 310, 312, 314).

5. The dispensing system of one of claims 1 to 4, wherein the controller (18) further is configured to dispense lines of material and/ or dots of material.

6. The dispensing system of one of claims 1 to 5, wherein the dispensing unit includes a sensor configured to sense a z-axis height on the electronic substrate.

7. The dispensing system of one of claims 1 to 6, further comprising a support assembly (22) coupled to the frame (20), the support assembly being configured to support the electronic substrate (12, 300) during a dispense operation.

8. A method of depositing material on an electronic substrate (12, 300) with a dispensing system (10) of the type including a frame (20), a dispensing unit gantry (24) movably coupled to the frame (20), a dispensing unit (14, 16) coupled to the dispensing unit gantry (24), the dispensing unit (14,16) being configured to deposit material onto the substrate (12, 300) during the dispense operation, a vision system gantry (32) coupled to the frame (20), and a vision system (30) coupled to the vision system gantry (32), the vision system (30) being configured to obtain one or more images of the electronic substrate (12, 300) prior to performing the dispense operation, wherein the area requiring dispensing is not well defined, the method comprising:
obtaining an image of a fiducial provided on the electronic substrate (12, 300);
orienting an object (304) with respect to the dispensing unit (14, 16); and
performing a dispense operation to secure the object (304) to the electronic substrate (12, 300),
**characterized by**
obtaining an image of at least a portion of the object (304), which is an electronic component mounted on the electronic substrate (12, 300);
determining an orientation of the object (304) based on a location of features of the object (304) with respect to a known location of the single fiducial of the electronic substrate (12, 300) and a position of the dispensing unit (14, 16).

9. The method of claim 8, wherein the method is performed under the control of a controller (18) configured to manipulate the vision system (30) with the vision system gantry (32) to move to a position defined by a feature of the object (304) and to acquire the image.

10. The method of claim 9, wherein the controller (18) further is configured to dispense lines of material and/or dots of material.

11. The method of one of claims 8 to 10, wherein performing a dispense operation includes dispensing material in the shape of an arc.

12. The method of one of claims 8 to 11, wherein the object (304) is a camera having a body (306) and a plurality of tabs (308, 310, 312, 314) extending from a periphery of the body.

13. The method of claim 12, wherein the dispensing unit (14, 16) is configured to dispense material between adjacent tabs (308, 310, 312, 314).

14. The method of one of claims 8 to 13, further comprising sensing a z-axis height on the electronic substrate (12, 300).

15. The method of one of claims 8 to 14, further comprising supporting the electronic substrate (12, 300) during a dispense operation with a support assembly (22) coupled to the frame (20).

## Patentansprüche

1. Abgabesystem zum Aufbringen von Material auf ein elektronisches Substrat (12, 300), wobei das Abgabesystem umfasst:
einen Rahmen (20);
ein mit dem Rahmen (20) beweglich gekoppelter Abgabeeinheitszugang (24);
eine Abgabeeinheit (14, 16), die mit dem Abgabeeinheitszugang (24) gekoppelt ist, wobei die Abgabeeinheit (14, 16) so konfiguriert ist, dass sie während des Abgabevorgangs Material auf das Substrat (12, 300) aufbringt;
ein Sichtsystemzugang (32), der mit dem Rahmen (20) gekoppelt ist;
ein Sichtsystem (30), das mit dem Sichtsystemzugang (32) gekoppelt ist, wobei das Sichtsystem (30) konfiguriert ist, um ein oder mehrere Bilder des elektronischen Substrats (12, 300) vor der Durchführung des Abgabevorgangs zu erhalten; und eine Steuerung (18), die mit dem Abgabeeinheitszugang (24), der Abgabeeinheit (14, 16), dem Sichtsystemzugang (32) und dem Sichtsystem (30) gekoppelt ist, wobei die Steuerung (18) konfiguriert ist, um ein Bild eines Referenzpunktes auf dem elektronischen Substrat (12, 300) zu erhalten,
einen Gegenstand (304) in Bezug auf die Abgabeeinheit (14, 16) auszurichten und einen Abgabevorgang durchführen, um den Gegenstand (304) an dem elektronischen Substrat (12, 300) zu befestigen,
**dadurch gekennzeichnet, dass**
die Steuerung (18) ferner konfiguriert ist, um ein Bild von mindestens einem Teil des Objekts (304) zu erhalten, das ein elektronisches Bauteil ist, das auf dem elektronischen Substrat (12, 300) montiert ist, und
weiter konfiguriert zur Bestimmung einer Orientierung des Objekts (304) basierend auf einer Position von Merkmalen des Objekts (304) in Bezug auf eine bekannte Position des einzelnen Referenzpunktes des elektronischen Substrats (12, 300) und einer Position der Abgabeeinheit (14, 16) .

2. Abgabesystem nach Anspruch 1, wobei die Steuerung (18) ferner konfiguriert ist, das Sichtsystem (30) mit dem Sichtsystemzugang (32) gezielt zu lenken, um sich zu einer durch ein Merkmal des Objekts (304) definierten Position zu bewegen und das Bild zu erfassen.

3. Abgabesystem nach Anspruch 1 oder 2, wobei die Durchführung eines Abgabevorgangs die Abgabe von Material in Form eines Bogens einschließt.

4. Abgabesystem nach einem der Ansprüche 1 bis 3, wobei das Objekt (304) eine Kamera mit einem Körper (306) und einer Vielzahl von Vorsprüngen (308, 310, 312, 314) ist, die sich von einem Umfang des Körpers (306) erstrecken, wobei
die Abgabeeinheit (14, 16) konfiguriert ist, Material zwischen benachbarten Vorsprüngen (308, 310, 312, 314) abzugeben.

5. Abgabesystem nach einem der Ansprüche 1 bis 4, wobei die Steuerung (18) ferner so konfiguriert ist, dass sie Materiallinien und/oder Materialpunkte abgibt.

6. Abgabesystem nach einem der Ansprüche 1 bis 5, wobei die Abgabeeinheit einen Sensor umfasst, der so konfiguriert ist, dass er eine z-Achsenhöhe auf dem elektronischen Substrat erfasst.

7. Abgabesystem nach einem der Ansprüche 1 bis 6, ferner umfassend eine mit dem Rahmen (20) verbundene Trägeranordnung (22), wobei die Trägeranordnung so konfiguriert ist, dass sie das elektronische Substrat (12, 300) während eines Abgabevorgangs trägt.

8. Verfahren zum Aufbringen von Material auf ein elektronisches Substrat (12, 300) mit einem Abgabesystem (10) dieses Typs mit einem Rahmen (20), einem Abgabeeinheitszugang (24), der beweglich mit dem Rahmen (20) gekoppelt ist, einer Abgabeeinheit (14, 16), die mit dem Abgabeeinheitszugang (24) gekoppelt ist, wobei die Abgabeeinheit (14, 16) konfiguriert ist, um während des Abgabevorgangs Material auf das Substrat (12, 300) abzuscheiden, ein Sichtsystemzugang (32), der mit dem Rahmen (20) gekoppelt ist, und ein Sichtsystem (30), das mit dem Sichtsystemzugang (32) gekoppelt ist, wobei das Sichtsystem (30) so konfiguriert ist, dass es ein oder mehrere Bilder des elektronischen Substrats (12, 300) vor der Durchführung der Abgabeoperation erhält, wobei der Bereich, der eine Abgabe erfordert, nicht genau definiert ist, wobei das Verfahren umfasst:
Aufnehmen eines Bilds eines Referenzpunktes auf dem elektronischen Substrat (12, 300);
Ausrichten eines Objekts (304) in Bezug auf die Abgabeeinheit (14, 16); und Durchführen eines Abgabevorgangs, um das Objekt (304) an dem elektronischen Substrat (12, 300) zu befestigen,
**gekennzeichnet durch**
die Aufnahme eines Bilds von mindestens einem Teil des Objekts (304), das ein auf dem elektronischen Substrat (12, 300) montiertes elektronisches Bauelement ist;
Bestimmung einer Orientierung des Objekts (304) auf der Grundlage einer Position von Merkmalen des Objekts (304) in Bezug auf eine bekannte Position des einzelnen Elements des elektronischen Substrats (12, 300) und einer Position der Abgabeeinheit (14, 16).

9. Verfahren nach Anspruch 8, wobei das Verfahren unter der Kontrolle einer Steuerung (18) durchgeführt wird, die konfiguriert ist, um das Sichtsystem (30) mit dem Sichtsystemzugang (32) gezielt zu lenken, um sich zu einer durch ein Merkmal des Objekts (304) definierten Position zu bewegen und das Bild zu erfassen.

10. Verfahren nach Anspruch 9, wobei die Steuerung (18) ferner so konfiguriert ist, dass sie Materiallinien und/oder Materialpunkte ausgibt.

11. Verfahren nach einem der Ansprüche 8 bis 10, wobei die Durchführung eines Abgabevorgangs die Abgabe von Material in Form eines Bogens einschließt.

12. Verfahren nach einem der Ansprüche 8 bis 11, wobei das Objekt (304) eine Kamera mit einem Körper (306) und einer Vielzahl von Vorsprüngen (308, 310, 312, 314) ist, die sich von einer Peripherie des Körpers erstrecken.

13. Verfahren nach Anspruch 12, wobei die Abgabeeinheit (14, 16) so konfiguriert ist, dass sie Material zwischen benachbarten Vorsprüngen (308, 310, 312, 314) abgibt.

14. Verfahren nach einem der Ansprüche 8 bis 13, umfassend ferner das Erfassen einer z-Achsenhöhe auf dem elektronischen Substrat (12, 300).

15. Verfahren nach einem der Ansprüche 8 bis 14, umfassend ferner das Tragen des elektronischen Substrats (12, 300) während eines Abgabevorgangs mit einer mit dem Rahmen (20) gekoppelten Trägeranordnung (22).

## Revendications

1. Système de distribution destiné à déposer un matériau sur un substrat électronique (12, 300), le système de distribution comprenant :
un cadre (20) ;
un portique d'unité de distribution (24) couplé de façon mobile au cadre (20) ;
une unité de distribution (14, 16) couplée au portique d'unité de distribution (24), l'unité de distribution (14, 16) étant configurée pour déposer un matériau sur le substrat (12, 300) pendant l'opération de distribution ;
un portique de système de vision (32) couplé au cadre (20) ;
un système de vision (30) couplé au portique de système de vision (32), le système de vision (30) étant configuré pour obtenir une ou plusieurs images du substrat électronique (12, 300) avant la réalisation de l'opération de distribution ; et
un contrôleur (18) couplé au portique d'unité de distribution (24), à l'unité de distribution (14, 16), au portique de système de vision (32) et au système de vision (30), le contrôleur (18) étant configuré pour
obtenir une image d'un repère apposé sur le substrat électronique (12, 300),
orienter un objet (304) par rapport à l'unité de distribution (14, 16), et
réaliser une opération de distribution pour fixer l'objet (304) au substrat électronique (12, 300),
**caractérisé en ce que**
le contrôleur (18) est également configuré pour obtenir une image d'au moins une partie de l'objet (304), qui est un composant électronique monté sur le substrat électronique (12, 300), et
également configuré pour déterminer une orientation de l'objet (304) sur la base d'un emplacement de caractéristiques de l'objet (304) par rapport à un emplacement connu de l'unique repère du substrat électronique (12, 300) et d'une position de l'unité de distribution (14, 16).

2. Système de distribution de la revendication 1, dans lequel le contrôleur (18) est également configuré pour manipuler le système de vision (30) avec le portique de système de vision (32) pour qu'il se déplace jusqu'à une position définie par une caractéristique de l'objet (304) et qu'il acquière l'image.

3. Système de distribution de la revendication 1 ou 2, dans lequel la réalisation d'une opération de distribution comporte la distribution d'un matériau sous la forme d'un arc.

4. Système de distribution d'une des revendications 1 à 3, dans lequel l'objet (304) est une caméra ayant un corps (306) et une pluralité de languettes (308, 310, 312, 314) s'étendant depuis une périphérie du corps (306),
dans lequel l'unité de distribution (14, 16) est configurée pour distribuer un matériau entre languettes adjacentes (308, 310, 312, 314).

5. Système de distribution d'une des revendications 1 à 4, dans lequel le contrôleur (18) est également configuré pour distribuer des lignes de matériau et/ou des points de matériau.

6. Système de distribution d'une des revendications 1 à 5, dans lequel l'unité de distribution comporte un capteur configuré pour détecter une hauteur sur un axe z au-dessus du substrat électronique.

7. Système de distribution d'une des revendications 1 à 6, comprenant en outre un ensemble support (22) couplé au cadre (20), l'ensemble support étant configuré pour supporter le substrat électronique (12, 300) pendant une opération de distribution.

8. Procédé de dépôt d'un matériau sur un substrat électronique (12, 300) avec un système de distribution (10) du type comportant un cadre (20), un portique d'unité de distribution (24) couplé de façon mobile au cadre (20), une unité de distribution (14, 16) couplée au portique d'unité de distribution (24), l'unité de distribution (14, 16) étant configurée pour déposer un matériau sur le substrat (12, 300) pendant l'opération de distribution, un portique de système de vision (32) couplé au cadre (20), et un système de vision (30) couplé au portique de système de vision (32), le système de vision (30) étant configuré pour obtenir une ou plusieurs images du substrat électronique (12, 300) avant la réalisation de l'opération de distribution, dans lequel la zone nécessitant une distribution n'est pas bien définie, le procédé comprenant :
l'obtention d'une image d'un repère apposé sur le substrat électronique (12, 300) ;
l'orientation d'un objet (304) par rapport à l'unité de distribution (14, 16) ; et
la réalisation d'une opération de distribution pour fixer l'objet (304) au substrat électronique (12, 300),
**caractérisé par**
l'obtention d'une image d'au moins une partie de l'objet (304), qui est un composant électronique monté sur le substrat électronique (12, 300) ;
la détermination d'une orientation de l'objet (304) sur la base d'un emplacement de caractéristiques de l'objet (304) par rapport à un emplacement connu de l'unique repère du substrat électronique (12, 300) et d'une position de l'unité de distribution (14, 16).

9. Procédé de la revendication 8, le procédé étant réalisé sous le contrôle d'un contrôleur (18) configuré pour manipuler le système de vision (30) avec le portique de système de vision (32) pour qu'il se déplace jusqu'à une position définie par une caractéristique de l'objet (304) et qu'il acquière l'image.

10. Procédé de la revendication 9, dans lequel le contrôleur (18) est également configuré pour distribuer des lignes de matériau et/ou des points de matériau.

11. Procédé d'une des revendications 8 à 10, dans lequel la réalisation d'une opération de distribution comporte la distribution d'un matériau sous la forme d'un arc.

12. Procédé d'une des revendications 8 à 11, dans lequel l'objet (304) est une caméra ayant un corps (306) et une pluralité de languettes (308, 310, 312, 314) s'étendant depuis une périphérie du corps.

13. Procédé de la revendication 12, dans lequel l'unité de distribution (14, 16) est configurée pour distribuer un matériau entre languettes adjacentes (308, 310, 312, 314) .

14. Procédé d'une des revendications 8 à 13, comprenant en outre la détection d'une hauteur sur un axe z au-dessus du substrat électronique (12, 300).

15. Procédé d'une des revendications 8 à 14, comprenant en outre le support du substrat électronique (12, 300) pendant une opération de distribution avec un ensemble support (22) couplé au cadre (20).
